# EUROPEAN PATENT APPLICATION

(11) **EP 4 769 486 A1**
(43) Date of publication of application: **01.07.2026**
(21) Application number: 24856320.7
(22) Date of filing: 08.08.2024
(51) Int. Cl.: H01L 21/677, B65G 49/07, B65G 54/02

(54) **SUBSTRATE PROCESSING DEVICE AND CONVEYANCE METHOD**

(30) Priority: 21.08.2023 JP 2023134101
(71) Applicant: Tokyo Electron Limited, Tokyo 107-6325 (JP)
(72) Inventor: AMIKURA, Norihiko, Kurokawa-gun, Miyagi 981-3629 (JP)
(74) Representative: Hoffmann Eitle
(86) International application number: PCT/JP2024/028409
(87) International publication number: WO 2025/041629

(57) **Abstract**

A substrate processing apparatus that performs processing on a substrate which is accommodated in a cassette and is to be transferred, includes: at least one transfer block configured to transfer the substrate in an interior of the at least one transfer block; a substrate processing module configured to perform the processing on the substrate; and a cassette transfer mechanism configured to transfer the cassette between a delivery position set on an outer surface of the substrate processing apparatus and a loading/unloading position at which the cassette is loaded into and unloaded from an interior of the substrate processing apparatus. The cassette transfer mechanism includes a stage on which the cassette is placed, and a moving mechanism configured to move the cassette placed on the stage.

## Description

### TECHNICAL FIELD

The present disclosure relates to a substrate processing apparatus and a transfer method.

### BACKGROUND

Patent Document 1 discloses a substrate processing apparatus that takes out a plurality of substrates from a carrier which accommodates the plurality of substrates to be transferred, and performs substrate processing on the taken-out substrates. In the substrate processing apparatus disclosed in Patent Document 1, the carrier is transferred with respect to a load port through which the carrier is loaded or unloaded, by an overhead hoist transport which moves along a track formed in a ceiling of a clean room where the substrate processing apparatus is installed.

### [Prior Art Document]

### [Patent Document]

Patent Document 1: Japanese Laid-Open Patent Publication No. 2014-116464

### SUMMARY

A technology according to the present disclosure improves an efficiency of transferring a cassette to a substrate processing apparatus.

According to an embodiment of the present disclosure, a substrate processing apparatus that performs processing on a substrate which is accommodated in a cassette and is to be transferred, includes: at least one transfer block configured to transfer the substrate in an interior of the at least one transfer block; a substrate processing module configured to perform the processing on the substrate; and a cassette transfer mechanism configured to transfer the cassette between a delivery position set on an outer surface of the substrate processing apparatus and a loading/unloading position at which the cassette is loaded into and unloaded from an interior of the substrate processing apparatus. The cassette transfer mechanism includes a stage on which the cassette is placed, and a moving mechanism configured to move the cassette placed on the stage.

According to the present disclosure, it is possible to improve an efficiency of transferring a cassette to a substrate processing apparatus.

### BRIEF DESCRIPTION OF DRAWINGS

FIG. 1 is a plan view schematically illustrating a configuration example of a substrate processing apparatus according to the present embodiment.
FIG. 2 is a perspective view illustrating a configuration example of the substrate processing apparatus according to the present embodiment.
FIG. 3 is a perspective view schematically illustrating a configuration example of a cassette transfer mechanism that moves along a horizontal plane.
FIG. 4 is a perspective view schematically illustrating a configuration example of the cassette transfer mechanism that moves along a vertical plane.
FIG. 5 is a flowchart for explain a flow of transferring a cassette.
FIG. 6 is an explanatory diagram illustrating a cassette retreat position in the substrate processing apparatus.
FIG. 7 is an explanatory diagram illustrating a cassette retreat position in the substrate processing apparatus.
FIG. 8 is a flowchart for explaining a flow of transferring a cassette.
FIG. 9 is a flowchart for explaining a flow of transferring a cassette.
FIG. 10 is a perspective view illustrating another configuration example of the substrate processing apparatus.
FIG. 11 is a perspective view illustrating another configuration example of the substrate processing apparatus.

### DETAILED DESCRIPTION

A cassette (FOUP), which serves as a storage container accommodating a plurality of (for example, 25 sheets of substrates per lot) semiconductor substrates (hereinafter, simply referred to as "substrates") is transferred to a substrate processing apparatus by an overhead hoist transport (OHT) which moves along a rail arranged on a ceiling surface of a clean room, as exemplified in Patent Document 1.

However, in the case of using the overhead hoist transport, an arrangement position of a load port of the substrate processing apparatus is limited within a movable range of the overhead hoist transport, that is, directly below the rail. This reduces a degree of freedom in the arrangement of the substrate processing apparatus. Further, even when unloading the cassette from the substrate processing apparatus, it is necessary to wait for the arrival of the overhead hoist transport in order to transfer the cassette C. This may cause a degradation in throughput.

A technology according to the present disclosure has been made in view of the above matters and improves a transfer efficiency of the cassette with respect to the substrate processing apparatus. Hereinafter, the substrate processing apparatus and a cassette transfer method carried out by the substrate processing apparatus according to the present embodiment will be described with reference to the drawings. In addition, in this specification and the accompanying drawings, constituent elements having substantially the same functional configuration will be denoted by the same reference numerals, and redundant descriptions thereof will be omitted.

### <Substrate Processing Apparatus>

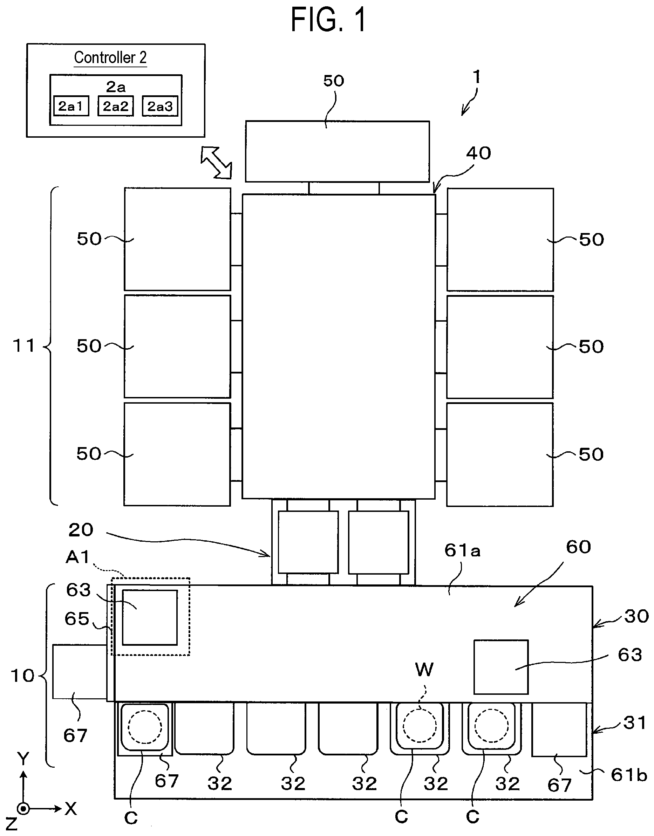

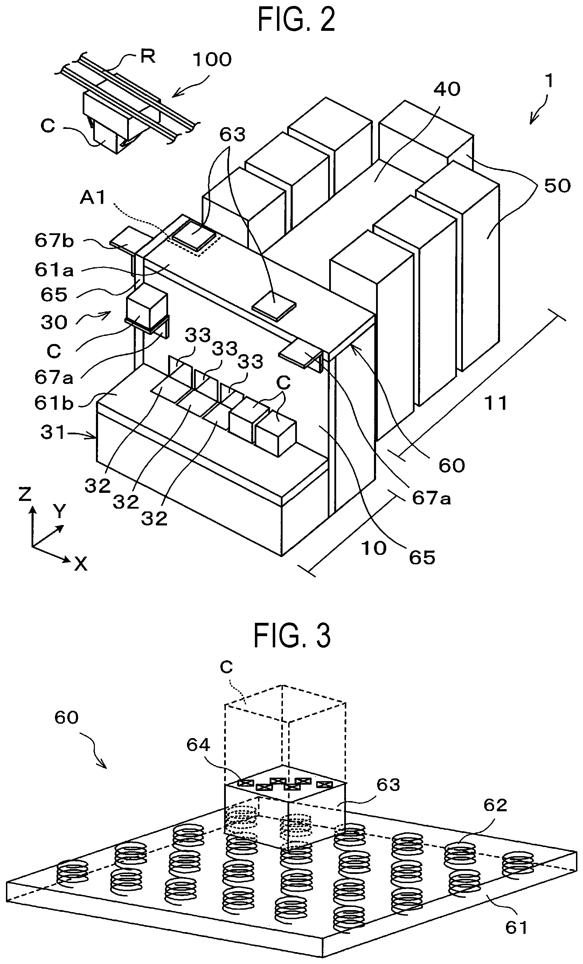

First, a configuration of the substrate processing apparatus according to the present embodiment will be described. FIGS. 1 and 2 are a plan view and a perspective view illustrating an outline of a configuration of a substrate processing apparatus 1 according to the present embodiment, respectively. In addition, a wafer is an example of a substrate.

The substrate processing apparatus 1 has a configuration in which an atmospheric section 10 and a depressurization section 11 are integrally connected to each other via a load lock module 20. The atmospheric section 10 includes an atmospheric module that processes and/or transfers a substrate W in an atmospheric atmosphere. The depressurization section 11 includes a depressurization module (vacuum module) that processes and/or transfers the substrate W in a depressurized (vacuum) atmosphere.

The load lock module 20 has an interior in which a load lock chamber (not illustrated) configured to temporarily hold the substrate W is provided. The load lock chamber is configured such that an internal space of the atmospheric section 10 and an internal space of the depressurization section 11 are in communication with each other via a substrate transfer port (not illustrated). Further, the load lock chamber is configured such that an interior thereof is switchable between the atmospheric atmosphere and a depressurized atmosphere (vacuum state). In other words, the load lock module 20 is configured such that the substrate W may be appropriately delivered between the atmospheric section 10 kept in the atmospheric atmosphere and the depressurization section 11 kept in the depressurized atmosphere.

The atmospheric section 10 includes an atmospheric transfer block 30 and a loading/unloading block 31. The loading/unloading block 31 is provided at a position lower than the atmospheric transfer block 30 by one stage. A plurality of (for example, five) load ports 32 are provided on an upper surface of the loading/unloading block 31. The load ports 32 correspond to loading/unloading positions of the substrate W with respect to the substrate processing apparatus 1. On each of the load ports 32, a cassette C accommodating a plurality of (for example, 25 sheets per lot) substrates W may be placed.

The atmospheric transfer block 30 has am interior of a rectangular housing shape, which is maintained in the atmospheric atmosphere. A substrate transfer mechanism (not illustrated) is arranged in the interior of the atmospheric transfer block 30. A plurality of (for example, five) substrate transfer ports 33 is formed on one side surface constituting one long side of the atmospheric transfer block 30 in a negative Y-axis direction. The above-described load ports 32 are arranged side by side to correspond to the substrate transfer ports 33, respectively. The load lock module 20 is arranged on the other side surface constituting the other long side of the atmospheric transfer block 30 in a positive Y-axis direction.

The depressurization section 11 includes a vacuum transfer block 40 and substrate processing modules 50. Interiors of the vacuum transfer block 40 and the substrate processing modules 50 are configured to be kept in the depressurized (vacuum) atmosphere. In addition, in the present embodiment, a plurality of (for example, seven) substrate processing modules 50 are connected to one vacuum transfer block 40. In addition, the number and arrangement of substrate processing modules 50 are not limited to those described in the present embodiment and may be set arbitrarily.

The vacuum transfer block 40 has an interior of a rectangular housing shape. A substrate transfer mechanism (not illustrated) is arranged in the interior of the vacuum transfer block 40. A plurality of (for example, three) substrate transfer ports (not illustrated) is formed on each of side surfaces constituting long sides of the atmospheric transfer block 40 in positive and negative X-axis directions. The substrate processing modules 50 are connected to correspond to the substrate transfer ports, respectively. A substrate transfer port (not illustrated) is also formed on one side surface constituting one short side of the vacuum transfer block 40 in the positive Y-axis direction, and the substrate processing module 50 is connected to the substrate transfer port. Further, the load lock module 20 is arranged on the other side surface constituting the other short side of the vacuum transfer block 40 in the negative Y-axis direction.

Each of the substrate processing module 50 performs desired processing on the substrate W transferred from the vacuum transfer block 40. The type and configuration of the substrate processing module 50 are not particularly limited. For example, the substrate processing modules 50 may take any configurations such as a coating/developing module, a plasma processing module and the like.

As illustrated in FIG. 2, the substrate processing apparatus 1 is provided with a cassette transfer mechanism 60 for transferring the cassette C, which is delivered from an overhead transfer mechanism 100 described later, to the load port 32. The cassette transfer mechanism 60 includes a horizontal-plane motor 61, a horizontal transfer unit 63, a vertical-plane motor 65, and a vertical transfer unit 67.

As illustrated in FIGS. 1 and 2, the horizontal-plane motor 61 includes a first horizontal-plane motor 61a on the atmospheric transfer block 30 and a second horizontal-plane motor 61b on the loading/unloading block 31, which are arranged to cover upper surfaces of the atmospheric transfer block 30 and the loading/unloading block 31, respectively. The first horizontal-plane motor 61a and the second horizontal-plane motor 61b have the same configuration. Thus, they may be collectively referred to simply as the "horizontal-plane motor 61" in the following description.

As illustrated in FIG. 3, a plurality of coils 62 (first coils) are arranged in an interior of the horizontal-plane motor 61. Each of the plurality of coils 62 generates a magnetic field by being supplied with current from a power supply (not illustrated). Power supplied to each of the plurality of coils 62 may be independently controlled, for example, under the control of a controller 2 described later.

On an outer surface of the substrate processing apparatus 1, specifically, on the first horizontal-plane motor 61a in the illustrated example, a delivery position A1 at which the cassette C is delivered to or from the overhead transfer mechanism 100 described later is set to a desired position at an end portion of the atmospheric transfer block 30 in negative and positive X-axis directions. Therefore, at least a position at which the delivery position A1 is set on the atmospheric transfer block 30 is defined directly below a rail R along which the overhead transfer mechanism 100 described later is transferred.

The horizontal transfer unit 63 is constituted as a columnar body having substantially the same cross-sectional shape as that of the cassette C in a plan view (that is, a rectangular columnar body in the illustrated example). The cassette C is placed on an upper surface of the horizontal transfer unit 63. Therefore, the horizontal transfer unit 63 constitutes a "stage" according to the technology of the present disclosure. Further, a plurality of permanent magnets 64 is arranged on the horizontal transfer unit 63. The horizontal transfer unit 63 magnetically levitates above the horizontal-plane motor 61 by the magnetic fields generated by the coils 62. A height of the horizontal transfer unit 63 levitating above the horizontal-plane motor 61 may be controlled by a magnitude of the current supplied to the coils 62. Further, the horizontal transfer unit 63 moves and rotates on the horizontal-plane motor 61 by the magnetic fields generated by the coils 62. Therefore, in the present embodiment, the horizontal-plane motor 61 and the horizontal transfer unit 63 may be collectively referred to as a "moving mechanism" according to the technology of the present disclosure.

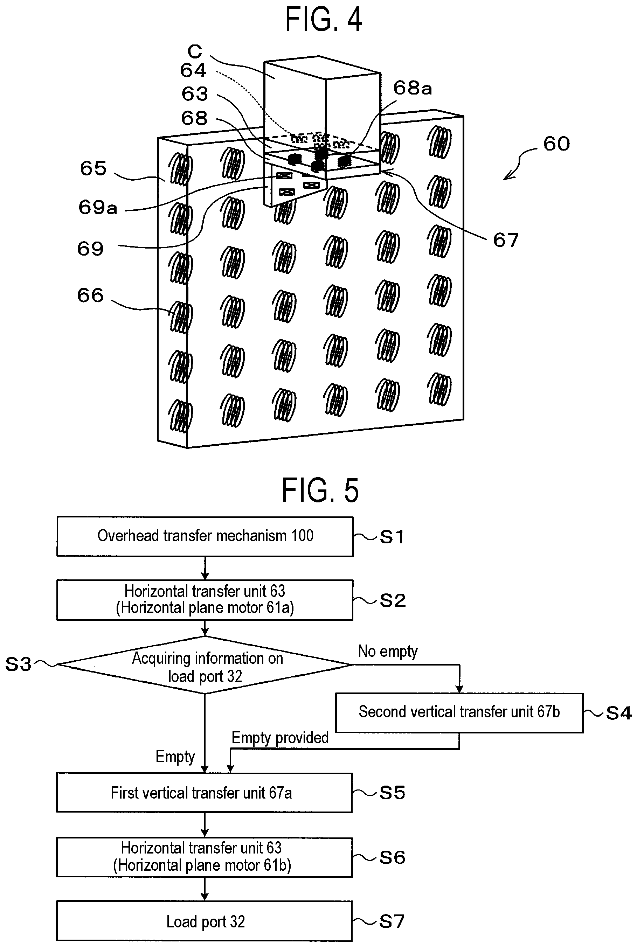

As illustrated in FIG. 2, the vertical-plane motor 65 is provided at a desired position on the side surface of the atmospheric transfer block 30, specifically in the illustrated example, on each of the side surface of the atmospheric transfer block 30 in the negative Y-axis direction, to which the loading/unloading block 31 is connected, and the side surface of the atmospheric transfer block 30 in the negative X-axis direction. As illustrated in FIG. 4, a plurality of coils 66 (second coils) is arranged in an interior of the vertical-plane motor 65. Each of the plurality of coils 66 generates a magnetic field by being supplied with current from a power supply (not illustrated). Power supplied to each of the plurality of coils 66 may be independently controlled, for example, under the control of the controller 2 described later.

The vertical transfer unit 67 includes a first vertical transfer unit 67a arranged on the side surface of the atmospheric transfer block 30 in the negative Y-axis direction, and a second vertical transfer unit 67b arranged on the side surface of the atmospheric transfer block 30 on the negative X-axis direction. The first vertical transfer units 67a and the second vertical transfer unit 67b have the same configuration. Thus, they may be collectively referred to simply as a "vertical transfer unit 67" in the following description.

The vertical transfer unit 67 includes a placement portion 68 having, for example, substantially the same cross-sectional shape as that of the cassette C in a plan view, and a moving portion 69 extending downward from an end of the placement portion 68 so as to face the vertical-plane motor 65.

The cassette C is placed on an upper surface of the placement portion 68. Further, a plurality of coils 68a is arranged on the placement portion 68. The horizontal transfer unit 63 magnetically levitates above the placement portion 68 by the magnetic fields generated by the coils 68a. Further, in the substrate processing apparatus 1, the horizontal transfer unit 63 may be delivered between the horizontal-plane motor 61 and the placement portion 68 under the control of the controller 2 described later. A height of the horizontal transfer unit 63 levitating above the placement portion 68 may be controlled by a magnitude of the current supplied to the coils 68a. Further, the horizontal transfer unit 63 moves and rotates on the placement portion 68 by the magnetic fields generated by the coils 68a.

The moving portion 69 is constituted with a planar body facing the vertical-plane motor 65. A plurality of permanent magnets 69a is arranged on the moving portion 69. Further, the moving portion 69 magnetically levitates along a plane direction of the vertical-plane motor 65 by the magnetic fields generated by the coils 66 of the vertical-plane motor 65. Therefore, the vertical transfer unit 67 moves along the vertical-plane motor 65 by the magnetic fields generated by the coils 66.

With this configuration, the first vertical transfer unit 67a may be configured to move the horizontal transfer unit 63 with the cassette C placed thereon between the atmospheric transfer block 30 and the loading/unloading block 31 by controlling the power supplied to each of the coils 62, 66 and 68a under the control of the controller 2.

Further, the second vertical transfer unit 67b may be configured to make the cassette C stand by while temporarily holding the cassette C on the side surface of the atmospheric transfer block 30 by controlling the power supplied to each of the coils 62, 66 and 68a under the control of the controller 2. Therefore, the second vertical transfer unit 67b may be configured as a buffer mechanism for the cassette C.

Therefore, the cassette transfer mechanism 60 transfers the cassette C, which is transferred from the overhead transfer mechanism 100, between the delivery position A1 and the load ports 32 (loading/unloading positions for the substrate W).

The substrate processing apparatus 1 is provided with the controller 2 as illustrated in FIG. 1. The controller 2 processes computer-executable instructions for causing the substrate processing apparatus 1 to execute various operations described in the present disclosure. The controller 2 may be configured to control individual constituent elements of the substrate processing apparatus 1 so as to execute various operations described herein. In one embodiment, a portion or the entirety of the controller 2 may be included in the substrate processing apparatus 1. The controller 2 may include a processor 2a1, a storage 2a2, and a communication interface 2a3. The controller 2 is implemented by, for example, a computer 2a. The processor 2a1 may be configured to execute various control operations by reading a program from the storage 2a2 and executing the read program. The program may be stored in advance in the storage 2a2, or may be acquired via a medium when necessary. The acquired program may be stored in the storage 2a2, and may be read from the storage 2a2 to be executed by the processor 2a1. The medium may be any of various storage media readable by the computer 2a, or may be a communication line connected to the communication interface 2a3. The processor 2a1 may be a central processing unit (CPU). The storage 2a2 may include a random access memory (RAM), a read only memory (ROM), a hard disk drive (HDD), a solid state drive (SSD), or a combination thereof. The communication interface 2a3 may communicate with the substrate processing apparatus 1 via a communication line such as a local area network (LAN). Further, the storage medium may be a transitory or non-transitory medium.

As illustrated in FIG. 2, the overhead transfer mechanism 100 is provided above the substrate processing apparatus 1 configured as above so as to move along the rail R provided on the ceiling surface of the clean room where the substrate processing apparatus 1 is arranged. The overhead transfer mechanism 100 may transfer the cassette C to and from another substrate processing apparatus 1 provided outside the substrate processing apparatus 1, and may access the delivery position A1 set on the upper surface of the atmospheric transfer block 30 from above to deliver the cassette C.

### <Cassette Transfer Method>

Next, a method of transferring the cassette C in the substrate processing apparatus 1 configured as above will be described in detail. FIG. 5 is a flowchart for explaining a flow of transferring the cassette C accommodating an unprocessed substrate W.

First, the overhead transfer mechanism 100, which holds a cassette (hereinafter, for the sake of convenience in description, a cassette to be transferred will be referred to as a "cassette C1") accommodating a plurality of unprocessed substrates W, moves above the delivery position A1 set on the first horizontal-plane motor 61a of the substrate processing apparatus 1 (Operation S1 in FIG. 5). At the delivery position A1, the horizontal transfer unit 63 on which another cassette (hereinafter, for the sake of convenience in description, referred to as "another cassette C2") is not place, is in a standby state in advance. The cassette C1 is directly delivered from the overhead transfer mechanism 100 to the horizontal transfer unit 63 (Operation S2 in FIG. 5).

Once the cassette C1 has been delivered to the horizontal transfer unit 63, the current is supplied to coils 62 of the first horizontal-plane motor 61a to magnetically levitate the horizontal transfer unit 63, and horizontally move the horizontal transfer unit 63. Further, at the same time, information about a placement status relating to another cassette C2 on the load ports 32 of the loading/unloading block 31, that is, information about an empty of the load ports 32 is acquired (Operation S3 in FIG. 5).

When all of the load ports 32 are not empty, that is, when another cassette C2 is already placed on all of the five load ports 32, the horizontal transfer unit 63 with the cassette C1 placed thereon moves to the placement portion 68 of the second vertical transfer unit 67b (Operation S4 in FIG. 5). At this time, the supply of the current to the coils 68a of the placement portion 68 may be performed in advance prior to the delivery of the cassette C1 to the placement portion 68, or may be performed simultaneously with the delivery of the cassette C1 to the placement portion 68. After the cassette C1 (the horizontal transfer unit 63) is transferred to the placement portion 68, the second vertical transfer unit 67b moves along the vertical-plane motor 65 when the current is supplied to the coils 66, and temporarily waits at a desired waiting position until an empty load port 32 is provided.

When the empty load port 32 is provided in Operation S3, or when the empty load port 32 is provided after the second vertical transfer unit 67b temporarily waits, the horizontal transfer unit 63 with the cassette C1 placed thereon moves to the placement portion 68 of the first vertical transfer unit 67a (Operation S5 in FIG. 5). At this time, the supply of the current to the coils 68a of the placement portion 68 may be performed in advance prior to the delivery of the cassette C1 to the placement portion 68, or may be performed simultaneously with the delivery of the cassette C1 to the placement portion 68. After the cassette C1 (the horizontal transfer unit 63) is delivered to the placement portion 68, the first vertical transfer unit 67a moves along the vertical-plane motor 65 when the current is supplied to the coils 66, and descends to a height position of the loading/unloading block 31.

Subsequently, after the first vertical transfer unit 67a descends, the horizontal transfer unit 63 with the cassette C1 placed thereon moves to the second horizontal-plane motor 61b (Operation S6 in FIG. 5). At this time, the supply of the current to the coils 62 of the second horizontal-plane motor 61b may be performed in advance prior to the delivery of the cassette C1 to the second horizontal-plane motor 61b, or may be performed simultaneously with the delivery of the cassette C1 to the second horizontal-plane motor 61b. The cassette C1 (the horizontal transfer unit 63) delivered to the second horizontal-plane motor 61b magnetically levitates and moves along the second horizontal-plane motor 61b when the current is supplied to the coils 62, and is placed on the load port 32 as a transfer destination (Operation S7 in FIG. 5). Thereafter, the substrate transfer port 33 of the atmospheric transfer block 30 is open, and the unprocessed substrates W in the cassette C1 are loaded into the substrate processing apparatus 1 by the substrate transfer mechanism (not illustrated). The unprocessed substrates W are subjected to various processes in the substrate processing modules 50.

In addition, in the case in which the cassette C is transferred from the placement portion 68 of the first vertical transfer unit 67a to the load port 32, for example, when the load port 32 as a transfer destination is at the center of the loading/unloading block 31 in the X-axis direction, interference may occur between the cassette C and another cassette C placed on another load port 32. This may make it difficult to appropriately transfer the cassette C1 to the corresponding load port 32.

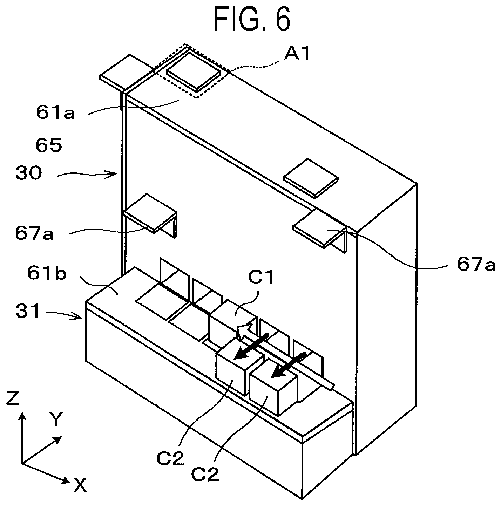

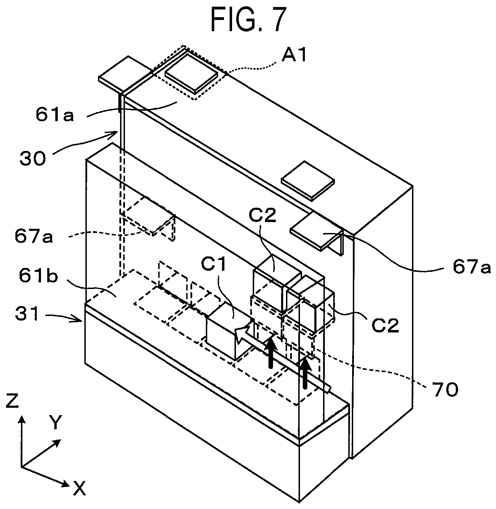

In view of the foregoing, as illustrated in FIG. 6, a retreat position for another cassette C2 may be provided in the loading/unloading block 31. As illustrated in FIG. 6, another cassette C2 may be provided on a side facing the substrate transfer port 33 with reference to the load port 32 (that is, a side of the load port 32 in the negative Y-axis direction). Alternatively, as illustrated in FIG. 7, the retreat position for another cassette C2 may be provided above the load port 32 (that is, on a side of the load port 32in a positive Z-axis direction). In this case, for example, a lifting mechanism 70 may be further provided to move another cassette C2 upward and downward by magnetic levitation. In addition, FIGS. 6 and 7 are merely illustrative examples.

Further, for example, in view of the foregoing, the first vertical transfer unit 67a may be configured to be independently and directly accessible to all of the load ports 32. In this case, the number of first vertical transfer units 67a arranged on the side surface of the atmospheric transfer block 30 in the negative Y-axis direction may be only one. Alternatively, a plurality of first vertical transfer units may be provided to correspond to the plurality of load ports 32, respectively.

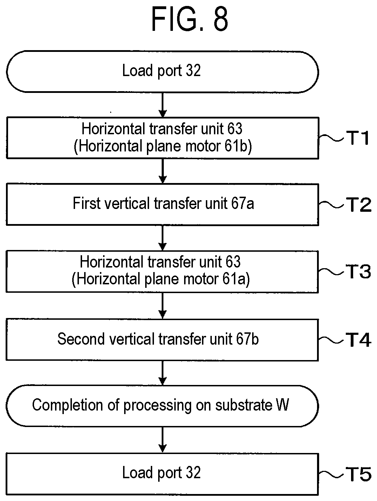

FIG. 8 is a flowchart for explaining a flow of transferring the empty cassette C1 from which the substrates Ware unloaded after Operation S7.

The empty cassette C1 from which the substrates W are unloaded temporarily waits in a buffer mechanism until all of the substrates W accommodated in the cassette C1 are processed. That is, the horizontal transfer unit 63 holding the empty cassette C1 first magnetically levitates and moves over the second horizontal-plane motor 61b when the current is supplied to the coils 62 (Operation T1 in FIG. 8), and is delivered to the placement portion 68 of the first vertical transfer unit 67a (Operation T2 in FIG. 8). At this time, in a case in which another cassette C2 is placed on another load port 32 along the transfer path of the cassette C1, as illustrated in FIG. 6 or FIG. 7, another cassette C2 may be temporarily moved to the retreat position.

Subsequently, after the horizontal transfer unit 63 is delivered to the placement portion 68, the first vertical transfer unit 67a magnetically levitates and moves along the vertical-plane motor 65 when the current is supplied to the coils 66, and ascends to the height position of the atmospheric transfer block 30. Subsequently, the horizontal transfer unit 63 with the cassette C1 placed thereon moves to the first horizontal-plane motor 61a (Operation T3 in FIG. 8), and is further delivered to the placement portion 68 of the second vertical transfer unit 67b (Operation T4 in FIG. 8).

Thereafter, the horizontal transfer unit 63 (the cassette C1) delivered to the placement portion 68 of the second vertical transfer unit 67b magnetically levitates and moves along the vertical-plane motor 65 when the current is supplied to the coils 66, and temporarily waits at a desired waiting position until all of the substrates W are processed.

In addition, in the example of the flowchart illustrated in FIG. 8, the cassette C1 temporarily waits in the second vertical transfer unit 67b (the buffer mechanism) provided on the side surface of the atmospheric transfer block 30 in the X-axis direction. However, the waiting position of the cassette C1 is not limited thereto. For example, as illustrated in FIG. 6 or FIG. 7, when the retreat position is provided near the load port 32, the cassette C1 may temporarily wait at the retreat position.

Subsequently, after the plurality of substrates W accommodated in the cassette C1 are processed, the cassette C1 (the horizontal transfer unit 63) in the waiting state moves to the load port 32 again (Operation T5 in FIG. 8), and the processed substrates W are returned from the interior of the substrate processing apparatus 1 to the empty cassette C1 via the substrate transfer port 33. In addition, a procedure of transferring the cassette C1 from the waiting position to the load port 32 is performed in the reverse order of the transfer method illustrated in FIG. 8.

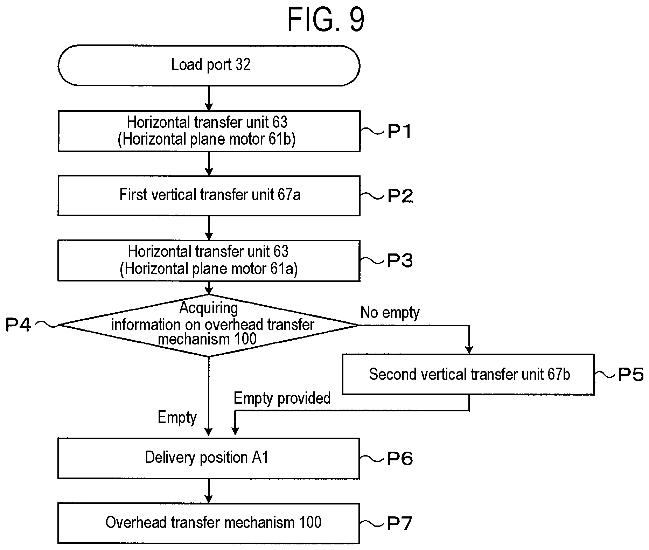

FIG. 9 is a flowchart for explaining a flow of transferring the empty cassette C1 from which the substrates W are unloaded.

The cassette C1 to which the processed substrates W are returned first magnetically levitates and moves over the second horizontal-plane motor 61b when the current is supplied to the coils 62 (Operation P1 in FIG. 9), and is delivered to the placement portion 68 of the first vertical transfer unit 67a (Operation P2 in FIG. 9). At this time, when another cassette C2 is placed on another load port 32 along the transfer path of the cassette C1, as illustrated in FIG. 6 or FIG. 7, another cassette C2 may be temporarily moved to the retreat position.

Subsequently, after the horizontal transfer unit 63 is delivered to the placement portion 68, the first vertical transfer unit 67a magnetically levitates and moves along the vertical-plane motor 65 when the current is supplied to the coils 66, and ascends to the height position of the atmospheric transfer block 30. Subsequently, the horizontal transfer unit 63 with the cassette C1 placed thereon moves to the first horizontal-plane motor 61a (Operation P3 in FIG. 9). Further, when the horizontal transfer unit 63 is moved from the load port 32 to the first horizontal-plane motor 61a, information about an operation of the overhead transfer mechanism 100 for unloading the cassette C1 from the substrate processing apparatus 1 is acquired (Operation P4 in FIG. 9).

When the overhead transfer mechanism 100 is being operated, that is, for example, when the overhead transfer mechanism 100 is transferring another cassette C2, the horizontal transfer unit 63 with the cassette C1 placed thereon moves to the placement portion 68 of the second vertical transfer unit 67b (Operation P5 in FIG. 9). After the cassette C1 (the horizontal transfer unit 63) is delivered to the placement portion 68, the second vertical transfer unit 67b moves along the vertical-plane motor 65 when the current is supplied to the coils 66, and temporarily waits at a desired waiting position until the overhead transfer mechanism 100 is in an operable state.

When the overhead transfer mechanism 100 is in the operable state in Operation P4, or when the overhead transfer mechanism 100 is in the operable state after the second vertical transfer unit 67b temporarily waits, the horizontal transfer unit 63 with the cassette C1 placed thereon moves to the delivery position A1 set on the first horizontal-plane motor 61a (Operation P6 in FIG. 9). Thereafter, the cassette C1 at the delivery position A1 is delivered to the overhead transfer mechanism 100 (Operation P7 in FIG. 9) that has directly accessed to the delivery position A1.

The transfer of the cassette C in the substrate processing apparatus 1 is performed in the procedure as described above.

As described above, in the substrate processing apparatus 1 according to the technology of the present disclosure, the cassette C transferred by the overhead transfer mechanism 100 may be freely transferred along motors (the horizontal-plane motor 61 and the vertical-plane motor 65) arranged on the outer surface of the substrate processing apparatus 1 by using the cassette transfer mechanism 60 provided in the substrate processing apparatus 1. Accordingly, unlike that disclosed in Patent Document 1, the cassette C transferred by the overhead transfer mechanism 100 does not need to directly access the load port 32. In the substrate processing apparatus 1, the overhead transfer mechanism 100 may access the delivery position A1, which may be set to any other positions, and may appropriately transfer the cassette C to the load port 32.

Further, with the above configuration, at least the delivery position A1 may be provided within a movable range of the overhead transfer mechanism 100, in other words, be located directly below the rail R. Thus, the load port 32 may not be provided within the movable range of the overhead transfer mechanism 100. Further, the delivery position A1 may be set to any other positions in the substrate processing apparatus 1 as described above. Therefore, the substrate processing apparatus 1 may be installed at any position in the clean room without being restricted by the movable range of the overhead transfer mechanism 100. This improves a degree of freedom in installation of the substrate processing apparatus 1, thereby enhancing the layout efficiency of the substrate processing apparatus 1 in the clean room.

Further, according to the above embodiments, the cassette C may move independently in the substrate processing apparatus 1 without using the overhead transfer mechanism 100. Accordingly, when the cassette C needs to be moved, there is no need to wait for the arrival of the overhead transfer mechanism 100. Therefore, the substrate processing performed by the substrate processing apparatus 1 is not limited by the overhead transfer mechanism 100. This significantly improves throughput.

Further, in the substrate processing apparatus 1 according to the technology of the present disclosure, the cassette C waits on the side surface of the substrate processing apparatus 1 through the magnetic levitation. In other words, the waiting position of the cassette C is not limited to the upper surface of the apparatus but may be set on other surfaces such as the side surface of the apparatus. This greatly enhances a degree of freedom in setting the waiting position.

Meanwhile, in a substrate processing apparatus in the related art as disclosed in Patent Document 1, for example, the overhead transfer mechanism directly accesses the load port. As a result, the number of cassettes C which may be simultaneously placed (delivered) in the substrate processing apparatus is limited to the number of load ports. In contrast, in the substrate processing apparatus 1 according to the technology of the present disclosure, the cassette C may be made to wait at any position by the second vertical transfer unit 67b. Thus, the cassettes C greater in number than the load ports 32 may be made to wait while being held at once. This further improves throughput of the substrate processing.

In addition, in the above embodiments, as illustrated in FIG. 2, the horizontal-plane motor 61 is arranged only on the upper surfaces of the atmospheric transfer block 30 and the loading/unloading block 31 of the atmospheric section 10. In other words, a horizontal transfer range (movement range) of the cassette C by the cassette transfer mechanism 60 is set on the upper surface of the atmospheric section 10. However, the arrangement of the horizontal-plane motor 61 is not limited to the example illustrated in FIG. 2.

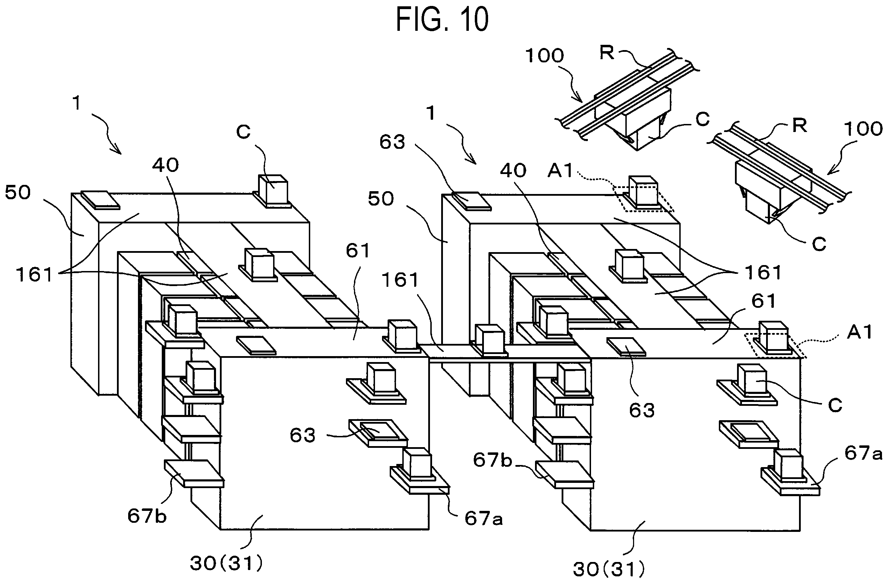

Specifically, for example, as illustrated in FIG. 10, an additional horizontal-plane motor 161 may be arranged on a rear side of the substrate processing apparatus 1 above the depressurization section 11 in the present embodiment. In this case, the additional horizontal-plane motor 161 may be directly arranged on the upper surface of the vacuum transfer block 40 or the substrate processing module 50. Alternatively, as illustrated in FIG. 10, the additional horizontal-plane motor 161 may be installed between the upper surface of the atmospheric transfer block 30 and the upper surface of the substrate processing module 50 so that the additional horizontal-plane motor 161 is spaced apart from the upper surface of the vacuum transfer block 40.

Further, in a case in which a plurality of substrate processing apparatuses 1 is arranged side by side inside a single clean room, as illustrated in FIG. 10, the additional horizontal-plane motor 161 may be installed between one substrate processing apparatus 1 and another substrate processing apparatus 1.

By installing the additional horizontal-plane motor 161 in this way, it is possible to expand the transfer range of the cassette C by the cassette transfer mechanism 60, and improve the degree of freedom in setting the delivery position A1 at which the cassette C is delivered to and from the overhead transfer mechanism 100. This improves a degree of freedom in installation of the substrate processing apparatus 1.

In addition, in the above embodiments, the case in which the cassette transfer mechanism 60 transfers the cassette C on the upper surface of the substrate processing apparatus 1 by using the magnetic levitation has been described as an example. However, the configuration of the cassette transfer mechanism 60 is not limited to this example as long as the cassette transfer mechanism 60 can transfer the cassette C to the load port of the substrate processing apparatus 1 independently of the overhead transfer mechanism 100.

Specifically, instead of the magnetic levitation, a moving mechanism including wheels, a power supply such as a battery, a drive source, a steering mechanism and the like may be used to transfer the cassette C. A base serving as a stage may be provided above the wheels and the cassette C may be placed on the base. Even in the case in which the cassette C is transferred using the wheels instead of the electromagnetic levitation, it is not necessary to arrange the load port 32 at least directly below the rail R of the overhead transfer mechanism 100. This makes it possible to improve a degree of freedom in installation of the substrate processing apparatus 1 and enhance a layout efficiency of the substrate processing apparatus 1 inside the clean room.

In addition, in the above embodiments, the substrate W has been described to be loaded or unloaded between the cassette C placed on the load port 32 and the interior of the substrate processing apparatus 1 via the substrate transfer port 33. However, the method of loading the substrate W into the substrate processing apparatus 1 is not limited thereto.

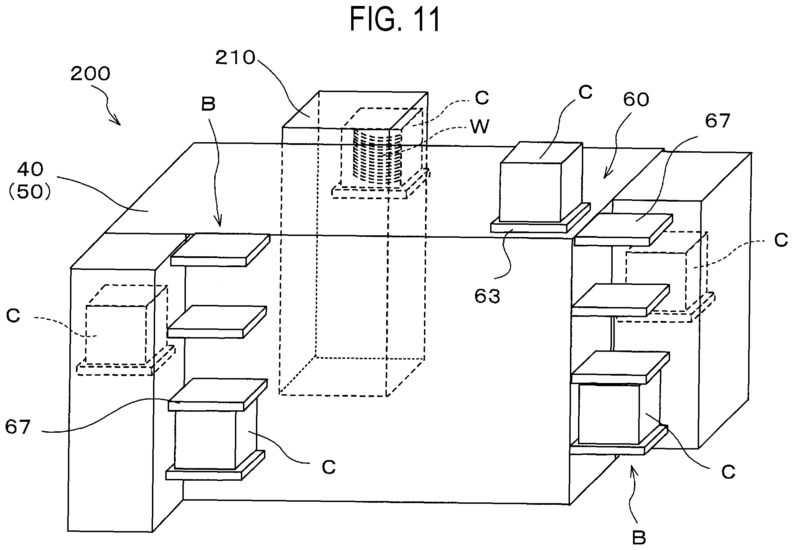

FIG. 11 is a perspective view schematically illustrating an outline of a configuration of a substrate processing apparatus 200 provided with a lifting mechanism 210 for loading the cassette C (the substrates W) into the substrate processing apparatus 200. In addition, in the substrate processing apparatus 200, constituent elements having substantially the same functional configuration as those of the substrate processing apparatus 1 described above will be denoted by the same reference numerals, and detailed descriptions thereof will be omitted.

The substrate processing apparatus 200 according to another embodiment includes the lifting mechanism 210, a vacuum transfer block 40, a substrate processing module 50, and a cassette transfer mechanism 60. The cassette transfer mechanism 60 transfers the cassette C at least on the upper surface of the vacuum transfer block 40 by the aforementioned method.

The lifting mechanism 210 places the cassette C which is delivered from the cassette transfer mechanism 60, in an interior of the lifting mechanism 210, and transfers (lifts) the substrates W between the exterior of the substrate processing apparatus 200 kept in an atmospheric atmosphere and the interior of the substrate processing apparatus 200 (the vacuum transfer block 40) kept in a depressurized atmosphere. Further, the lifting mechanism 210 is configured such that the interior thereof is switchable between the atmospheric atmosphere and the depressurized atmosphere (vacuum state). Therefore, it can be said that the lifting mechanism 210 of the present embodiment is configured to have the functions of the atmospheric transfer block 30, the loading/unloading block 31, and the load lock module 20 of the substrate processing apparatus 1 described above. Therefore, in the present embodiment, the lifting mechanism 210 is configured to provide the loading/unloading position for the substrates W with respect to the substrate processing apparatus 200.

Further, in the substrate processing apparatus 200, first, the cassette C delivered from the overhead transfer mechanism 100 is transferred to the lifting mechanism 210 by the horizontal transfer unit 63 of the cassette transfer mechanism 60. Subsequently, the lid of the cassette C is open such that the interior of the cassette C is brought into communication with the interior of the lifting mechanism 210, and the interior of the lifting mechanism 210 (the cassette C) is depressurized. Subsequently, the lifting mechanism 210 receives one or more substrates W from the interior of the cassette C, and descends (transfers) the received substrates W from a height position of the upper surface of the substrate processing apparatus 200 to a height position of the interior of the vacuum transfer block 40 (that is, the interior of the substrate processing apparatus 200). The substrates W loaded into the substrate processing apparatus 200 temporarily wait in the interior of the lifting mechanism 210 or in a stocker provided in the substrate processing apparatus 200 independently of the lifting mechanism 210. Thereafter, the substrates W are transferred to the substrate processing module 50 via the vacuum transfer block 40 so that the substrates W are subjected to desired processing in the substrate processing module 50.

Subsequently, the empty cassette C from which all of the substrates W are unloaded, waits at the buffer position set on the outer surface of the substrate processing apparatus 200 until all of the unloaded substrates W are processed. Specifically, the empty cassette C is transferred from the lifting mechanism 210 to the vertical transfer unit 67 by the horizontal transfer unit 63. Then, the vertical transfer unit 67 moves the empty cassette C to a predetermined buffer position B (*see* FIG. 11) along a vertical-plane motor (not illustrated in FIG. 11) provided on a side surface of the substrate processing apparatus 200. The empty cassette C waits at the predetermined buffer position B.

The embodiments disclosed herein are intended to be illustrative and not restrictive in all respects. The above embodiments may be omitted, replaced or modified in various ways without departing from the scope or spirit of the appended claims.

### EXPLANATION OF REFERENCE NUMERALS

1: Substrate processing apparatus
30: Atmospheric transfer block
31: Loading/unloading block
32: Load port
40: Vacuum transfer block
50: Substrate processing module
60: Cassette transfer mechanism
61: Horizontal plane motor
62: Coil
63: Horizontal transfer unit
64: Permanent magnet
100: Overhead transfer mechanism
A1: Delivery position
C: Cassette
W: Substrate

## Claims

1. A substrate processing apparatus that performs processing on a substrate which is accommodated in a cassette and is to be transferred, comprising:
at least one transfer block configured to transfer the substrate in an interior of the at least one transfer block;
a substrate processing module configured to perform the processing on the substrate;
and
a cassette transfer mechanism configured to transfer the cassette between a delivery position set on an outer surface of the substrate processing apparatus and a loading/unloading position at which the cassette is loaded into and unloaded from an interior of the substrate processing apparatus,
wherein the cassette transfer mechanism includes:
a stage on which the cassette is placed; and
a moving mechanism configured to move the cassette placed on the stage.

2. The substrate processing apparatus of Claim 1, wherein the cassette transfer mechanism includes:
a horizontal-plane motor including a plurality of first coils arranged on an upper surface of the transfer block; and
a horizontal transfer unit configured to move over the horizontal-plane motor while magnetically levitating over the horizontal-plane motor using a magnetic field generated by the plurality of first coils.

3. The substrate processing apparatus of Claim 2, wherein the cassette transfer mechanism further includes:
a vertical-plane motor including a plurality of second coils arranged on a side surface of the transfer block; and
a vertical transfer unit configured to move along the vertical-plane motor using a magnetic field generated by the plurality of second coils.

4. The substrate processing apparatus of Claim 2 or 3, further comprising: an additional horizontal-plane motor installed between the upper surface of the transfer block and an upper surface of the substrate processing module.

5. The substrate processing apparatus of Claim 2 or 3, further comprising: an additional horizontal-plane motor installed between an upper surface of the substrate processing apparatus and an upper surface of an additional substrate processing apparatus that performs the processing on the substrate which is accommodated in the cassette and is to be transferred.

6. The substrate processing apparatus of Claim 1, further comprising: a lifting mechanism configured to move the cassette upward and downward between a height position of an upper surface of the transfer block and a height position of an interior of the transfer block,
wherein the lifting mechanism has an interior configured to be switched between an atmospheric atmosphere and a vacuum atmosphere.

7. The substrate processing apparatus of Claim 1, wherein the cassette is transferred between an outside of of the substrate processing apparatus and the delivery position by an overhead transfer mechanism.

8. A transfer method of transferring a cassette to a substrate processing apparatus,
wherein the substrate processing apparatus comprises:
at least one transfer block configured to transfer a substrate to be processed in an interior of the at least one transfer block;
a substrate processing module configured to perform processing on the substrate; and
a cassette transfer mechanism configured to transfer the cassette between a delivery position set on an outer surface of the substrate processing apparatus and a loading/unloading position at which the cassette is loaded into and unloaded from an interior of the substrate processing apparatus, and
wherein the transfer method comprising:
delivering the cassette, which is transferred from an outside of the substrate processing apparatus, to the cassette transfer mechanism at the delivery position;
moving the cassette transfer mechanism from the delivery position to the loading/unloading position; and
delivering the substrate accommodated in the cassette to the substrate processing apparatus at the loading/unloading position.

9. The transfer method of Claim 8, wherein the moving the cassette transfer mechanism includes:
supplying a current to a horizontal-plane motor including a plurality of first coils arranged on an upper surface of the transfer block;
magnetically levitating a horizontal transfer unit on which the cassette is placed on the horizontal-plane motor using a magnetic field generated by the plurality of first coils; and
moving the horizontal transfer unit on the horizontal-plane motor by controlling the current supplied to the plurality of first coils.

10. The transfer method of Claim 9, wherein the moving the cassette transfer mechanism includes:
supplying a current to a vertical-plane motor including a plurality of second coils arranged on a side surface of the transfer block; and
moving a vertical transfer unit along the vertical-plane motor by controlling the current supplied to the plurality of second coils.

11. The transfer method of Claim 10, further comprising: temporarily making the cassette standby at a buffer position, prior to moving the cassette to the loading/unloading position when another cassette is placed at the loading/unloading position,
wherein the buffer position is formed on the side surface of the transfer block.

12. The transfer method of Claim 8, wherein the cassette is transferred between the outside of the substrate processing apparatus and the delivery position by an overhead transfer mechanism.
